# EUROPEAN PATENT APPLICATION

(11) **EP 2 584 594 A1**
(43) Date of publication of application: **24.04.2013**
(21) Application number: 11795436.2
(22) Date of filing: 23.02.2011
(51) Int. Cl.: H01L 21/336, H01L 21/302, H01L 21/304, H01L 21/316, H01L 29/12, H01L 29/78

(54) **METHOD FOR MANUFACTURING SILICON CARBIDE SEMICONDUCTOR DEVICE AND APPARATUS FOR MANUFACTURING SILICON CARBIDE SEMICONDUCTOR DEVICE**

(30) Priority: 16.06.2010 JP 2010136866
(71) Applicant: Sumitomo Electric Industries, Ltd., Osaka-shi, Osaka 541-0041 (JP)
(72) Inventor: ITOH, Satomi, Osaka-shi Osaka 554-0024 (JP); SHIOMI, Hiromu, Osaka-shi Osaka 554-0024 (JP); NAMIKAWA, Yasuo, Itami-shi Hyogo 664-0016 (JP); WADA, Keiji, Osaka-shi Osaka 554-0024 (JP); SHIMAZU, Mitsuru, Osaka-shi Osaka 554-0024 (JP); HIYOSHI, Toru, Osaka-shi Osaka 554-0024 (JP)
(74) Representative: Grünecker, Kinkeldey, Stockmair & Schwanhäusser
(86) International application number: PCT/JP2011/054010
(87) International publication number: WO 2011/158528

(57) **Abstract**

A method of fabricating a SiC semiconductor device (200) includes the steps of preparing a silicon carbide semiconductor (100) including a first surface (100a) having impurities implanted at least partially, forming a second surface (100b) by dry etching the first surface (100a) of the silicon carbide semiconductor (100) using gas including hydrogen gas, and forming an oxide film (126) constituting the silicon carbide semiconductor device (200) on the second surface (100b).

## Description

### TECHNICAL FIELD

The present invention relates to a method and apparatus of fabricating a silicon carbide (SiC) semiconductor device. More particularly, the present invention relates to a method of fabricating a SiC semiconductor device having an oxide film, and a fabrication apparatus employed in this fabrication method.

### BACKGROUND ART

Conventionally, silicon (Si) is widely employed as the material constituting a semiconductor device. A Si semiconductor device, for example, a MOSFET (Metal Oxide Semiconductor Field Effect Transistor) can be fabricated as set forth below.

First, an epitaxial layer is grown on a silicon (Si) substrate to produce a Si semiconductor. Then, an ion implantation step is carried out for the purpose of introducing impurities (dopant) to the Si semiconductor. Then, the Si semiconductor is subjected to a heating process (activation annealing process) to activate the introduced impurities. Then, a gate oxide film is formed on the surface of the Si semiconductor subsequent to the heating process, and an electrode is formed on the gate oxide film.

In the conventional fabrication of a Si semiconductor device, cleaning is carried out to remove attachments such as particles and/or impurities of metal, adhering to the surface of the Si substrate. For such a cleaning method, a cleaning method employing chemical solution such as RCA cleaning is widely employed.

In RCA cleaning, a Si oxide film is formed on the surface of the Si substrate by cleaning the surface of the Si substrate with a chemical solution including sulfuric acid and hydrogen peroxide. Particles and metal impurities are present in and at the surface of the Si oxide film. This Si substrate is rinsed with diluted hydrofluoric acid solution to etch away the Si oxide film and remove together the particles and metal impurities.

As another cleaning method, Japanese Patent Laying-Open No. 6-314679 (PTL 1) and Japanese Patent Laying-Open No. 4-354334 (PTL 2) disclose the method of oxidizing the surface of a Si substrate using ozone water and then removing the oxide film to take away particles and metal impurities on the Si substrate.

### CITATION LIST

### PATENT LITERATURE

PTL 1: Japanese Patent Laying-Open No. 6-314679
PTL 2: Japanese Patent Laying-Open No. 4-354334

### SUMMARY OF INVENTION

### TECHNICAL PROBLEM

SiC is known to have a large band gap, as well as maximum breakdown field and heat conductivity greater than those of Si, while the carrier mobility is of a comparable level to Si. The electron saturation drift rate and breakdown voltage are also great. Therefore, the expectation for application of SiC to semiconductor devices requiring high efficiency, high breakdown voltage, and large capacitance is great. The inventors drew their attention to employ a SiC semiconductor for a semiconductor device. In order to fabricate a SiC semiconductor substrate of higher quality, the inventors conceived of cleaning the surface of the SiC semiconductor to form an oxide film constituting the SiC semiconductor device.

The inventors were the first to reveal that the surface of a SiC semiconductor is not readily oxidized, in the case where the conventional cleaning method set forth above is applied to SiC semiconductors, since SiC is a compound more thermally stable than Si. The cleaning method set forth above allows the surface of Si to be oxidized, but not the surface of SiC to a sufficient level. Therefore, particles and impurities could not be removed from the surface of SiC. Thus, the SiC surface cannot be cleaned sufficiently. If the surface of the SiC semiconductor cannot be cleaned, an oxide film cannot be formed on a cleaned SiC semiconductor. As a result, the quality of the fabricated SiC semiconductor device will be degraded.

Therefore, an object of the present invention is to provide a method of fabricating a SiC semiconductor device of high quality, and a fabrication apparatus employed in this method.

### SOLUTION TO PROBLEM

The present invention was completed as a result of diligent study on cleaning the surface of a SiC semiconductor for the purpose of fabricating a SiC semiconductor device of high quality. The present invention is directed to a method of fabricating a SiC semiconductor device, including the steps of preparing a SiC semiconductor having a first surface to which impurities (dopant) are implanted at least partially, forming a second surface by dry etching the first surface of the SiC semiconductor using gas containing hydrogen gas, and forming an oxide film constituting the SiC semiconductor device on the second surface.

According to the method of fabricating a SiC semiconductor device of the present invention, the first surface of the SiC semiconductor having impurities implanted at least partially is dry etched using gas containing hydrogen gas (hereinafter, also referred to as "hydrogen-etching"). Accordingly, impurities, particles and the like adhering to the first surface can be removed, allowing formation of a cleaned second surface. By forming an oxide film constituting the SiC semiconductor device on the cleaned second surface, a SiC semiconductor device of high quality can be fabricated. Since the SiC semiconductor is a stable compound, damage to the SiC semiconductor is small even if hydrogen-etching is applied. Therefore, the SiC semiconductor can be cleaned such that the surface property is rendered favorable. Thus, a SiC semiconductor device of high quality can be fabricated.

Preferably in the method of fabricating a SiC semiconductor device set forth above, the step of forming an oxide film is carried out absent of cleaning using a liquid phase, after the step of forming a second surface.

Accordingly, adherence of impurities caused by rinsing using a liquid phase can be prevented. Thus, a SiC semiconductor device of further high quality can be fabricated.

Preferably in the step of forming a second surface in the method of fabricating a SiC semiconductor device set forth above, hydrogen-etching is carried out in a temperature range greater than or equal to 1300°C and less than or equal to 1650°C.

By carrying out hydrogen-etching at a temperature greater than or equal to 1300°C, the etching rate can be increased. By carrying out hydrogen-etching at a temperature less than or equal to 1650°C, control is rendered feasible since the etching rate can be prevented from becoming too high. In other words, by carrying out hydrogen-etching in the aforementioned temperature range, control at a favorable etching rate is allowed. Therefore, the first surface can be etched with higher accuracy, leading to improvement of the quality of the SiC semiconductor device.

Preferably in the method of fabricating a SiC semiconductor device set forth above, the step of forming an oxide film is carried out by forming a film containing silicon (Si) on the second surface, and oxidizing the film containing Si.

The inventors completed the invention by drawing their attention to the fact that the oxidization rate in the depth direction varies, leading to formation of an uneven oxide film, due to the difference in the impurity (dopant) concentration and the type of impurities (dopant) at the second surface of the SiC semiconductor having impurities (dopant) implanted at least partially. Since the film containing Si is formed on the second surface, influence of the state of the second surface on the quality of the film containing Si can be reduced. Therefore, the quality of the film containing Si can be rendered uniform. Thus, the quality of the SiC semiconductor device can be further improved.

Preferably in the step of forming a second surface in the method of fabricating a SiC semiconductor device set forth above, the gas further includes hydrogen chloride gas.

By using hydrogen chloride gas together with hydrogen gas in hydrogen-etching the first surface of the SiC semiconductor, the etching rate of the SiC semiconductor can be increased. Therefore, the fabrication takt of a SiC semiconductor device can be shortened.

Preferably in the step of forming a second surface in the method of fabricating a SiC semiconductor device set forth above, the gas further includes hydrocarbon gas.

By using hydrocarbon gas together with hydrogen gas in hydrogen-etching the first surface of the SiC semiconductor, the surface morphology of the SiC semiconductor can be rendered favorable. Therefore, the quality of the SiC semiconductor device can be further improved.

Preferably in the method of fabricating a SiC semiconductor device set forth above, the SiC semiconductor is arranged in an atmosphere where the air is cut off between the step of forming a second surface and the step of forming an oxide film.

Accordingly, the SiC semiconductor having a clean second surface formed can be transferred to the next step of forming an oxide film constituting a SiC semiconductor device without being exposed to the air. Thus, the cleaned surface of the SiC semiconductor can be prevented from being contaminated by the air, allowing the quality of the SiC semiconductor to be further improved.

The present invention is also directed to a fabrication apparatus of a SiC semiconductor device, including a removal unit for removing a first surface having impurities (dopant) implanted at least partially by dry etching using gas containing hydrogen gas, a formation unit for forming an oxide film constituting a SiC semiconductor device on a second surface of the SiC semiconductor formed by having the first surface removed, and a connection unit connecting the removal unit and the formation unit in a manner allow the SiC semiconductor to be transferred. The region at the connection unit where the SiC semiconductor is transferred can have the air cut off.

According to the fabrication apparatus, the first surface of the SiC semiconductor having impurities implanted at least partially can be hydrogen-etched at the removal unit. The SiC semiconductor subjected to hydrogen-etching at the removal unit can be transferred to the formation unit via the connection unit under an atmosphere cut off from the air. Furthermore, at the formation unit, an oxide film constituting the SiC semiconductor device can be formed on the second surface. In other words, the series of steps from cleaning the SiC semiconductor by hydrogen-etching to the step of forming an oxide film can be carried out under a state cut off from the air. Therefore, a SiC semiconductor device of high quality can be fabricated by the fabrication apparatus.

### ADVANTAGEOUS EFFECTS OF INVENTION

According to the fabrication method of a SiC semiconductor device and a fabrication apparatus employed in the fabrication method of the present invention, a SiC semiconductor device of high quality can be fabricated using the cleaning method of a SiC semiconductor exhibiting cleaning of the SiC semiconductor.

### BRIEF DESCRIPTION OF DRAWINGS

Fig. 1 is a schematic view of a fabrication apparatus of a SiC semiconductor device according to a first embodiment of the present invention.
Fig. 2 is a flowchart of a fabrication method of a SiC semiconductor device according to the first embodiment of the present invention.
Fig. 3 is a schematic sectional view of a SiC semiconductor prepared in the first embodiment of the present invention.
Fig. 4 is a diagram to describe a production step of a SiC semiconductor prepared in the first embodiment of the present invention.
Fig. 5 is a schematic sectional view of a SiC semiconductor having an oxide film formed in the first embodiment of the present invention.
Fig. 6 is a schematic sectional view of a SiC semiconductor having a source contact electrode and a drain electrode formed in the first embodiment of the present invention.
Fig. 7 is a schematic sectional view of a SiC semiconductor device fabricated in the first embodiment of the present invention.
Fig. 8 is a schematic sectional view of a SiC semiconductor having a semiconductor film formed on a main surface of the SiC semiconductor according to a second embodiment of the present invention.
Fig. 9 is a schematic sectional view of an epitaxial wafer employed in Example 1, and Comparative Examples 1 and 2.
Fig. 10 represents a spectrum of the results of the surface of a SiC semiconductor of Comparative Example 1 measured by TXRF.
Fig. 11 represents a spectrum of the results of the surface of a SiC semiconductor of Comparative Example 2 measured by TXRF.

### DESCRIPTION OF EMBODIMENTS

Embodiments of the present invention will be described hereinafter with reference to the drawings. In the drawings, the same or corresponding elements have the same reference characters allotted, and description thereof will not be repeated.

### (First Embodiment)

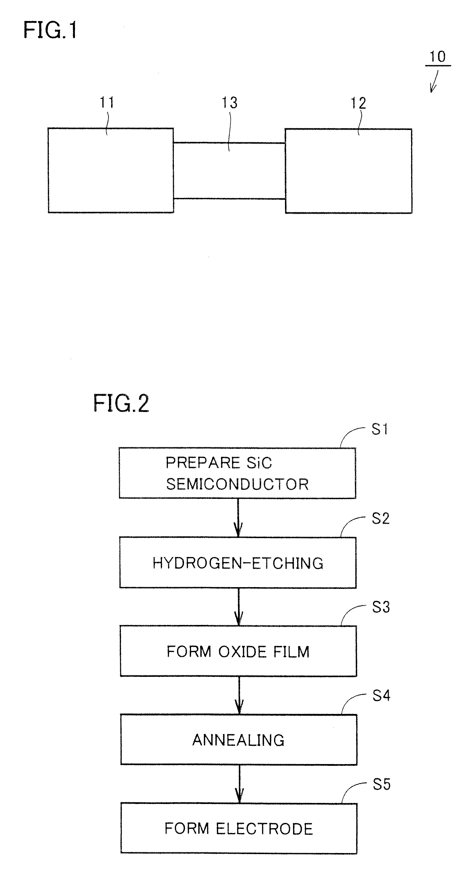

Fig. 1 is a schematic view of a fabrication apparatus of a SiC semiconductor device according to a first embodiment of the present invention. A fabrication apparatus of a SiC semiconductor device according to a first embodiment of the present invention will be described with reference to Fig. 1.

As shown in Fig. 1, a fabrication apparatus 10 of a SiC semiconductor device includes a removal unit 11, a formation unit 12, and a connection unit 13. Removal unit 11 and formation unit 12 are connected by connection unit 13. The interior of removal unit 11, formation unit 12, and connection unit 13 is cut off from the air, and allows communication with each other.

Removal unit 11 forms a second surface by hydrogen-etching a first surface of a SiC semiconductor having impurities implanted at least partially. For removal unit 11, a hydrogen-etching device is employed. The hydrogen-etching device used for removal unit 11 is not particularly limited. A high frequency furnace, for example, may be employed.

Formation unit 12 forms an oxide film constituting the SiC semiconductor device on the second surface. For formation unit 12, an oxide film formation device is employed. The oxide film formation device employed for formation unit 12 is not particularly limited. For example, a dry oxidation (thermal oxidation) device, a sputtering device, a CVD (Chemical Vapor Deposition) device, a wet oxidation device for heating in an oxygen atmosphere including vapor, or a pyrogenic oxidation device may be used. Preferably, a dry oxidation device is used.

Connection unit 13 connects removal unit 11 and formation unit 12 in a manner allowing transfer of a SiC semiconductor. The region where an epitaxial wafer is transferred in connection unit 13 (internal space) can have the air cut off.

As used herein, cutting off the air (an atmosphere having the air cut off) implies an atmosphere into which the air is not mixed, consisting of at least one type of nitrogen gas, hydrogen gas, and inert gas, or in vacuum. Specifically, the atmosphere having the air cut off is an atmosphere filled with gas of nitrogen (N), hydrogen (H), helium (He), neon (Ne), argon (Ar), krypton (Kr), xenon (Xe), radon (Rn), or a combination thereof, or in vacuum.

Connection unit 13 allows communication between the interior of removal unit 11 and the interior of formation unit 12. Connection unit 13 includes therein the space for delivering a SiC semiconductor carried out from removal unit 11 to formation unit 12. Specifically, connection unit 13 is provided to deliver a SiC semiconductor from removal unit 11 to formation unit 12, avoiding exposure to the air.

Connection unit 13 has a size that allows a SiC semiconductor to be transferred therein. Connection unit 13 may be sized to allow a SiC semiconductor to be carried in a state mounted on a susceptor. Connection unit 13 is a load lock chamber joining the outlet of removal unit 11 and the inlet of formation unit 12, for example.

Fabrication apparatus 10 may further include a first transfer unit arranged in connection unit 13 to transfer a SiC semiconductor from removal unit 11 to formation unit 12. Fabrication apparatus 10 may further include a second transfer unit to take a SiC semiconductor having gate oxide film 126 formed at formation unit 12 outside of fabrication apparatus 10, or to deliver the SiC semiconductor to an electrode formation unit where an electrode is to be formed under an atmosphere having the air cut off. The first transfer unit and second transfer unit may be identical or different.

Moreover, fabrication apparatus 10 may further include a cut off unit arranged between removal unit 11 and connection unit 13 to block the interior of removal unit 11 and the interior of connection unit 13. Fabrication apparatus 10 may further include a cut off unit arranged between formation unit 12 and connection unit 13 to block the interior of formation unit 12 and the interi or of connection unit 13. For the cut off unit, a valve, a door, or the like that can block each communication can be used.

Fabrication apparatus 10 may further include a vacuum pump to discharge the atmosphere gas inside, and/or an exchange gas cylinder to exchange the atmosphere gas inside. The vacuum pump and/or exchange gas cylinder may be connected to each of, or at least one of removal unit 11, formation unit 12, and connection unit 13.

Although fabrication apparatus 10 may include various elements other than those set forth above, for example an electrode formation unit to form an electrode on the oxide film, illustration and description of such other elements are not provided for the sake of simplification.

The present invention is not particularly limited to the configuration in which connection unit 13 is provided connecting only removal unit 11 and formation unit 12. For example, a chamber having the air cut off may be used for connection unit 13, and removal unit 11 and formation unit 12 may be arranged in the chamber.

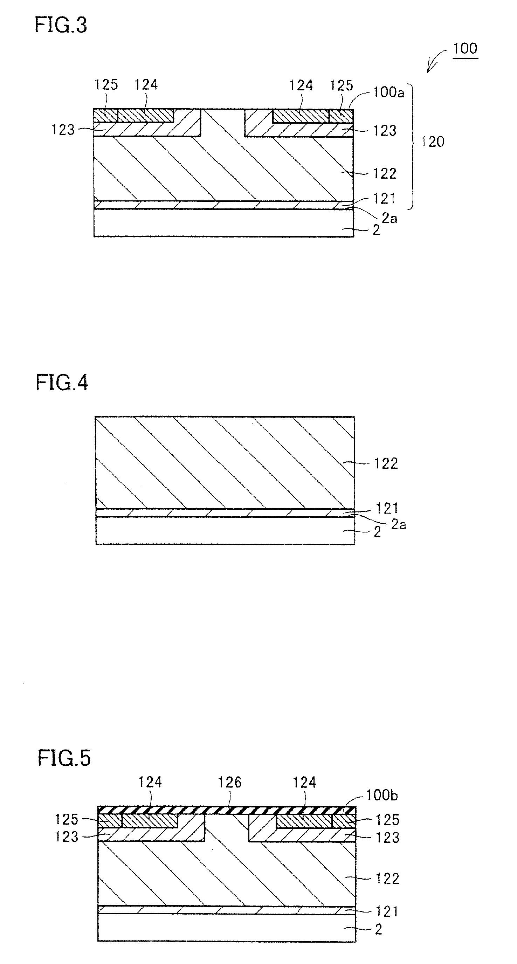

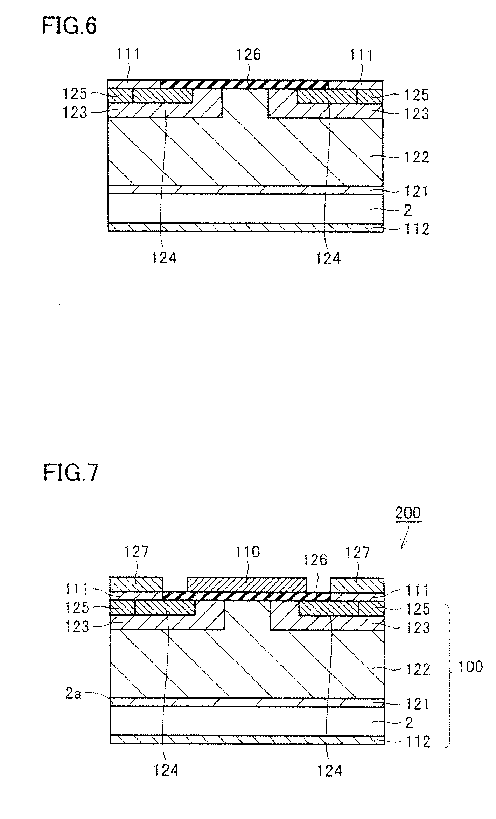

A method of fabricating a SiC semiconductor device according to the present embodiment will be described hereinafter with reference to Figs. 1-7. Fig. 2 is a flowchart of the fabrication method of a SiC semiconductor device according to the first embodiment of the present invention. Figs. 3-6 represent a configuration of a SiC semiconductor formed at each step in the fabrication method of a SiC semiconductor device according to the first embodiment of the present invention. Specifically, Fig. 3 is a sectional view schematically representing a SiC semiconductor that is prepared. Fig. 4 is a diagram to describe the step of producing a SiC semiconductor that is prepared. Fig. 5 is a sectional view schematically showing a SiC semiconductor having an oxide film formed. Fig. 6 is a sectional view schematically showing a SiC semiconductor having a source contact electrode and drain electrode formed. Fig. 7 is a sectional view schematically representing a SiC semiconductor device fabricated according to the first embodiment of the present invention. In the present embodiment, a method of fabricating a SiC semiconductor device 200 shown in Fig. 7 will be described as a SiC semiconductor. In the present embodiment, fabrication apparatus 10 of a SiC semiconductor device shown in Fig. 1 is used.

As shown Figs. 2 and 3, an epitaxial wafer 100 is prepared, as a SiC semiconductor including a first surface 100a having impurities implanted at least partially (step S1). In the present step, an epitaxial wafer 100 is formed as a SiC semiconductor, including an epitaxial layer 220 having a region where impurities are implanted, on a surface 2a of a SiC substrate 2, as shown in Fig. 2. SiC substrate 2 can be prepared by, but not particularly limited to, the method set forth below.

Specifically, a SiC ingot grown by sublimation, vapor deposition such as CVD, or liquid phase growth is prepared. Then, a SiC substrate having a surface is cut out from the SiC ingot. The cutting method is not particularly limited. A SiC substrate is cut out from the SiC ingot by slicing or the like.

Then, the surface of the SiC substrate cut out is polished. The surface to be polished may be only the top surface, or also the back surface opposite to the top surface. The method of polishing is, but not particularly limited to CMP (Chemical Mechanical Polishing) to render the surface flat and to reduce any damage such as scratching. In CMP, colloidal silica is employed for the abrading agent; and an adhesive or wax is employed for the fixative. In addition to or alternative to CMP, other polishing methods such as electropolishing, chemical polishing, and mechanical polishing may be performed. Alternatively, polishing is dispensable. Thus, SiC substrate 2 having surface 2a shown in Fig. 1 can be prepared. As such a SiC substrate 2, a substrate of n type conductivity, and having a resistance of 0.02 Ωcm can be used

Epitaxial layer 120 on SiC substrate 2 can be formed by, for example, the method set forth below. As shown in Fig. 4, a buffer layer 121 is formed on surface 2a of SiC substrate 2. Buffer layer 121 is an epitaxial layer formed of SiC of n type conductivity, having a thickness of 0.5 µm, for example. The concentration of the n type conductivity impurities at buffer layer 121 is 5 × 10¹⁷cm⁻³, for example. Then, a drift layer 122 is formed on buffer layer 121. For drift layer 122, a layer of n type conductivity of SiC is formed by vapor phase deposition, liquid phase growth or the like. Drift layer 122 has a thickness of 10 µm, for example. The concentration of the n type conductivity impurities of drift layer 122 is 5 × 10¹⁵ cm⁻³, for example.

Then, impurities are implanted into the epitaxial layer. In the present embodiment, a p body region 123, an n source region 124, and a p⁺ region 125 are formed as set forth below, as shown in Fig. 3. First, p type conductivity impurities are selectively implanted into a portion of drift layer 122 to form a body region 123. Then, n type conductivity impurities are selectively implanted to a predetermined region to form a source region 124, and p type conductivity impurities are implanted selectively to a predetermined region to form p⁺ region 125. Selective implantation of conductive impurities is carried out using a mask formed of an oxide film, for example.

In the impurity implantation step, the thickness to be removed by hydrogen-etching at step S2 that will be described afterwards is taken into account for each implantation profile. In other words, ion implantation is controlled such that, when first surface 100a of the epitaxial layer is removed by hydrogen-etching at step S2, the impurity diffusion region including p body region 123, n source region 124, and p⁺ region 125 is arranged as desired.

An activation annealing process may be carried out after such an implantation step. For example, annealing is carried out for 30 minutes at the heating temperature of 1700°C in an argon atmosphere.

By these steps, there can be prepared an epitaxial wafer 100 including a SiC substrate 2 and an epitaxial layer 120 formed on SiC substrate 2.

Returning to Fig. 2, first surface 100a of the prepared epitaxial wafer 100 is hydrogen-etched to form a second surface 100b (refer to Fig. 5) (step S2). At step S2 in the present embodiment, first surface 100a is removed at removal unit 11 of fabrication apparatus 10 shown in Fig. 1.

By carrying out this step S2, first surface 100a of epitaxial layer 120 is hydrogen-etched. Accordingly, impurities, particles and the like adhering to first surface 100a are removed together with first surface 100a. At epitaxial wafer 100, a cleaned second surface 100b is obtained by the removal of impurities, particles and the like (Fig. 5).

In view of the amount of etching readily controlled at step S2, the etching depth (the amount of etching in the direction from first surface 100a to SiC substrate 2) is preferably greater than or equal to 0.1 µm, more preferably greater than or equal to 0.5 µm.

From the standpoint of removing impurities, particles, and the like, the etching depth is greater than or equal to 1 molecular layer and less than or equal to 10 nm. By hydrogen-etching first surface 100a at a thickness of this range, impurities, particles and the like adhering to first surface 100a can be removed reliably, allowing a cleaned second surface 100b to be obtained.

Although the surface region of the Si semiconductor may be damaged by the aforementioned implantation step to be roughened, the roughened surface region can be removed together with the removal of impurities, particles, and the like by setting the etching depth greater than 10 nm and less than or equal to 500 nm. Therefore, by hydrogen-etching first surface 100a at a thickness of this range, the damaged layer can be removed together with the impurities, particles, and the like. Second surface 100b of favorable surface property can be obtained.

Hydrogen-etching carried out at a temperature greater than or equal to 1300°C allows the etching rate to be increased, and at a temperature less than or equal to 1650°C allows the etching rate from being too high, rendering control feasible. Since control at a favorable etching rate is allowed by adjusting the temperature condition of hydrogen-etching to be at 1300°C to 1650°C, first surface 100a can be etched at higher accuracy. Thus, the quality of the SiC semiconductor device can be further improved. Such a temperature setting is allowed by heating epitaxial wafer 100 arranged in an etching device (removal unit 11) at 1300°C to 1650°C, or by introducing gas directed to etching (hereinafter, referred to as "etching gas") at a temperature of 1300°C to 1650°C into the apparatus, or by maintaining the interior of the apparatus at 1300°C to 1650°C. It is to be noted that a combination thereof may be employed.

The flow rate of hydrogen gas during hydrogen-etching is not particularly limited to, but preferably about several hundred slm (standard liter per minute), and the pressure during hydrogen-etching is preferably about several ten hPa to several hundred hPa. Within this range, etching can be carried out at a favorable rate.

For etching gas, mixture gas of hydrogen gas and another gas may be used. Particularly, mixture gas having hydrogen chloride (HCl) gas mixed to hydrogen gas is preferable. By using such mixture gas, the etching rate can be increased. If the content by percentage of hydrogen chloride gas in the mixture gas is too high, the etching rate will become so great that it will become difficult to control etching. The content by percentage of hydrogen chloride gas in the mixture gas is preferably less than or equal to 10%. More preferably, the content by percentage of hydrogen chloride gas in the mixture gas of hydrogen chloride gas and hydrogen gas (hydrogen chloride gas/(hydrogen chloride gas + hydrogen gas) × 100) is less than or equal to 10%.

Mixture gas having hydrocarbon gas mixed into hydrogen gas may also be used. By using such mixture gas, etching can be carried out while rendering the surface morphology of epitaxial wafer 100 favorable. Therefore, second surface 100b having a favorable surface state can be formed. For hydrocarbon, low hydrocarbon such as alkane and alkene may be used. For example, acetylene (C₂H₂), propane (C₃H₈) or the like may be used. Such hydrocarbon gas is preferably mixed at a ratio less than or equal to 1000 ppm to effectively exhibit the advantage of suppressing generation of Si droplets. It is needless to say that mixture gas having hydrogen gas, hydrogen chloride gas, and hydrocarbon gas mixed may be employed as the etching gas.

Referring to Fig. 1, epitaxial wafer 100 having second surface 100b formed at removal unit 11 is transferred to formation unit 12. At this stage, epitaxial wafer 100 is transferred into connection unit 13 based on an atmosphere having the air cut off. In other words, between step S2 of forming second surface 100b and step S3 of forming gate oxide film 126, epitaxial wafer 100 is arranged in an atmosphere having the air cut off. This is to prevent impurities included in the air from adhering to second surface 100b, subsequent to being cleaned.

By using fabrication apparatus 10 shown in Fig. 1, step S3 of forming an oxide film that will be described afterwards can be carried out without any cleaning using a liquid phase, subsequent to the step of forming second surface 100b (step S2). Thus, the adhesion of impurities (particularly, heavy metal ion, alkali ion) caused by cleaning using a liquid phase can be suppressed. Cleaning using a liquid phase means that epitaxial wafer 100 identified as a SiC semiconductor is rinsed in a liquid phase, and may include an unintended vapor phase component.

As shown in Figs. 2 and 5, a gate oxide film 126 constituting SiC semiconductor device 200 is formed on second surface 100b (step S3).

At step S3, the well-known method for forming an oxide film can be employed. The well-known method includes, for example, dry oxidation, sputtering, CVD, wet oxidation, pyrogenic oxidation, and the like.

At step S3, by virtue of second surface 100b being cleaned, the insulation property of gate oxide film 126 can be improved. In addition, impurities, particles and the like present at the interface between epitaxial wafer 100 and gate oxide film 126 and in gate oxide film 126 can be reduced. Accordingly, the breakdown voltage of SiC semiconductor device 200 when reverse voltage is applied, and the stability as well as long-term reliability of the operation when forward voltage is applied can be improved.

As shown in Fig. 2, gate oxide film 126 is subjected to annealing (step S4). At step S4, a nitriding process and inert gas annealing process are applied to gate oxide film 126.

The nitriding process corresponds to thermal treatment in an atmosphere containing nitrogen. As the nitriding process, annealing can be carried out for 120 minutes at the heating temperature of 1200°C in a nitrogen oxide (NO) atmosphere or dinitrogen oxide (N₂O) atmosphere. Accordingly, at the region including the interface between epitaxial layer 120 and gate oxide film 126, a high nitrogen concentration region (not shown) having a nitrogen concentration higher than that of an adjacent region is formed.

In an inert gas annealing process, thermal treatment is carried out in an atmosphere including inert gas. In the inert gas annealing process, annealing is carried out for 60 minutes at the heating temperature of 1100°C in an inert gas atmosphere such as of argon (Ar) gas.

In the case where the above-described nitriding process and inert gas annealing process are carried out, the tendency of realizing high channel mobility with favorable reproducibility is increased at SiC semiconductor device 200. It is to be noted that only one of the nitrogen process and inert gas annealing process may be carried out. Alternatively, the present step (step S4) may be omitted.

As shown in Figs. 2 and 7, a gate electrode 110, a source electrode 127, and a drain electrode 112 are formed at epitaxial wafer 100 having gate oxide film 126 formed (step S5).

Gate electrode 110 and source electrode 127 can be formed by, for example, the method set forth below. By photolithography, a resist film having a pattern is formed on gate oxide film 126. Using this resist film as a mask, gate oxide film 126 is partially removed. Then, a conductor film made of metal is formed by a well-known method, for example, vapor deposition. The resist film is removed (lifted off) to remove the conductor film on the resist film to form source contact electrode 111 (refer to Fig. 6). Then, source electrode 127 is formed on source contact electrode 111 by a well-known method, for example, vapor deposition, followed by formation of gate electrode 110 on gate oxide film 126 by a well-known method, for example, vapor deposition. Drain electrode 112 can be formed by a well-known method, for example, vapor deposition, at the side opposite to surface 2a of SiC substrate 2. By carrying out the steps set forth above (steps S1-S5), SiC semiconductor device 200 shown in Fig. 7 is produced.

The present embodiment has been described based on, but not particularly limited to an example in which another cleaning method such as wet cleaning is not carried out between step S2 and step S3. Another cleaning method such as wet cleaning, dry cleaning, or the like may be carried out. In the case where another cleaning method is carried out, epitaxial wafer 100 is preferably arranged in an atmosphere having the air cut off during its transfer.

After step S1, a cleaning step through a chemical solution, a deionized water rinsing step, a drying step, or the like may be additionally carried out, as necessary. For the chemical solution, SPM including sulfuric acid and hydrogen peroxide solution can be cited. In the case where cleaning with SPM is carried out prior to step S2, organic substances can be removed. RCA cleaning and the like may be carried out prior to step S2.

As described above, the fabrication method of a SiC semiconductor device according to the present embodiment includes the steps of preparing an epitaxial wafer 100 with a first surface 100a having impurities implanted at least partially (step S), forming a second surface 100b by hydrogen-etching first surface 100a (step S2), and forming a gate oxide film 126 constituting SiC semiconductor device 200 on second surface 100b (step S3).

The inventors were the first to reveal that the surface of an epitaxial wafer 100 is not readily oxidized in the case where the conventional cleaning method is applied to epitaxial wafer 100, since SiC is a compound more stable than S1, leading to insufficient cleaning of the surface of epitaxial wafer 100.

The inventors drew their attention that epitaxial wafer 100 is chemically stable, not readily damaged even when subjected to a method that causes damage with Si. As a result of diligent study of the conditions for cleaning the surface of epitaxial wafer 100, the present inventors arrived at the fabrication method of epitaxial wafer 100 according to the present embodiment set forth above.

By hydrogen-etching first surface 100a of epitaxial wafer 100 at step S2 in the present embodiment, impurities, particles and the like adhering to first surface 100a are removed, allowing formation of a cleaned second surface 100b. Furthermore, since gate oxide film 126 is formed on a cleaned second surface 100b at step S3, the insulation property of gate oxide film 126 in the semiconductor device can be improved, and impurities, particles and the like present at the interface between epitaxial wafer 100 and gate oxide film 126 as well as in gate oxide film 126 can be reduced. Therefore, the breakdown voltage of SiC semiconductor device 200 when a reverse voltage is applied can be improved, and the stability and long-term reliability in the operation when forward voltage is applied can be improved. According to the fabrication method of a SiC semiconductor device of the present embodiment, a SiC semiconductor device 200 of high quality can be produced. Furthermore, since the damage to epitaxial wafer 100 by hydrogen-etching is small, a second surface 100b having a favorable surface property can be obtained. Accordingly, a SiC semiconductor device 200 of high quality can be eventually produced.

In the case where first surface 100a was damaged by an ion implantation step or by activation annealing, the formation and removal of a sacrificial oxide film were carried out conventionally through cleaning using a liquid phase. In order to remove a damaged layer formed at first surface 100a through cleaning using a liquid phase, a cleaning time of approximately 15 hours was required. In contrast, by virtue of hydrogen-etching absent of cleaning using a liquid phase, the damaged layer formed at first surface 100a can be removed together with particles, impurities, and the like in approximately 4 hours. Therefore, the fabrication method of a SiC semiconductor device according to the present embodiment can shorten the fabrication takt by virtue of not carrying out cleaning using a liquid phase between step S2 and step S3.

"Carrying out a step of forming gate oxide film 126 (step S3) absent of cleaning using a liquid phase, subsequent to the step of forming second surface 100b (step S2)" implies that a cleaning step using the liquid phase is not included between step S2 and step S3, and that step S2 and step S3 may be carried out intermittently (i.e. time may elapse between these steps). Alternatively, step S2 and step S3 may be carried out continuously.

Upon diligent study, the inventors found that, when epitaxial wafer 100 was cleaned using a liquid phase, the cleaning of epitaxial wafer 100 is not only insufficient, but also causes adherence of impurities instead.

Therefore, in the fabrication method of a SiC semiconductor device according to the present embodiment, the step of forming a gate oxide film 126 (step S3) is preferably carried out without cleaning using a liquid phase, after the step of forming a second surface 100b (step S2). By forming a gate oxide film 126 after the step of forming a second surface 100b without cleaning using a liquid phase, adherence of impurities caused by cleaning using a liquid phase can be prevented. Thus, a SiC semiconductor device 200 of further high quality can be produced.

The fabrication method of a SiC semiconductor device according to the present embodiment can be suitably used for a semiconductor device including an oxide film since the property of the oxide film can be improved by forming the oxide film at the surface of a cleaned epitaxial wafer. Although the present embodiment has been described based on the case where a MOSFET is fabricated, the present embodiment is suitably applicable to a semiconductor device having an insulation gate field effect section such as an IGBT (Insulated Gate Bipolar Transistor), a JFET (Junction Field-Effect Transistor), and the like.

### (Second Embodiment)

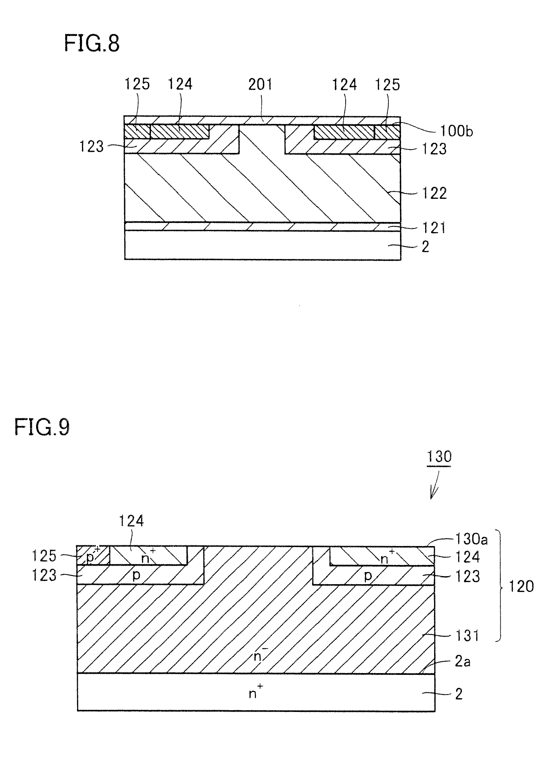

Fig. 8 is a schematic sectional view of a SiC semiconductor having a semiconductor film formed on a main surface of a SiC semiconductor according to a second embodiment of the present invention. The fabrication method of a SiC semiconductor device according to the second embodiment will be described with reference to Figs. 2-8.

As shown in Figs. 2 and 3, an epitaxial wafer 100 is prepared, including an epitaxial layer 120 with a region having impurities (dopant) implanted, formed on surface 2a of SiC substrate (step S1). Since step S1 is similar to that of the first embodiment, description thereof will not be repeated.

Then, as shown in Fig. 2, first surface 100a of the prepared epitaxial wafer 100 is hydrogen-etched to form a second surface 100b (step S2). Since step S2 is similar to that of the first embodiment, description thereof will not be repeated.

As shown in Figs. 2 and 8, a semiconductor film 201 containing silicon (Si) is formed on second surface 100b. Then, semiconductor film 201 is oxidized to form a gate oxide film 126 (step S3), as shown in Fig. 5.

For the method of forming semiconductor film 201 containing Si on second surface 100b, the well-known epitaxial growth, for example, CVD can be employed.

In the present step, a semiconductor film 201 of Si or silicon carbide (SiC) may be formed. In the case where semiconductor film 201 is formed of Si, the quality of the fabricated semiconductor device can be further improved since the presence of carbon at the interface between epitaxial wafer 100 and gate oxide film 126 as well as in gate oxide film 126 can be suppressed. In the case where semiconductor film 201 is formed of SiC, semiconductor film 201 can be formed readily since the crystal of underlying epitaxial layer 120 is identical to the crystal of semiconductor film 201.

At step S3, the thickness of gate oxide film 126 is determined and preferably the thickness of semiconductor film 201 is controlled such that, when semiconductor film 201 is completely oxidized (without oxidizing epitaxial wafer 100 below semiconductor film 201), gate oxide film 126 has the determined thickness. In other words, the thickness of semiconductor film 201 is preferably determined according to the thickness of gate oxide film 126 corresponding to the complete oxidation of semiconductor film 201. This can be realized by controlling the thickness of semiconductor film 201 by calculation and the like taking into consideration the increase of the film thickness caused by the introduction of oxygen (O) when semiconductor film 201 is oxidized to become gate oxide film 126.

In the case where semiconductor film 201 is formed of Si, semiconductor film 201 is preferably formed to have a thickness approximately 0.44 times the desired thickness of the oxide film. By such designing of the thickness of semiconductor film 201, gate oxide film 126 can be obtained at the designed thickness even if the film thickness increases by introduction of oxygen when semiconductor film 201 is oxidized to become gate oxide film 126. At this stage, it is preferable to form gate oxide film 126 by oxidizing only semiconductor film 201, not epitaxial wafer 100, to avoid including the impurities of ion-implanted epitaxial wafer 100. Accordingly, the effect of epitaxial wafer 100 to the ion implantation profile can be reduced.

The oxidization method of semiconductor film 201 is not particularly limited, and dry oxidation, wet oxidation, pyrogenic oxidation, and the like may be employed.

As shown in Fig. 2, gate oxide film 126 is subjected to annealing (step S4). Since step S4 is similar to that of the first embodiment, description thereof will not be repeated.

As shown in Figs. 2 and 7, a gate electrode 110, a source electrode 127 and a drain electrode 112 are formed at epitaxial wafer 100 having gate oxide film 126 formed (step S5). Since step S5 is similar to that of the first embodiment, description thereof will not be repeated. By carrying out the steps set forth above (steps S1-S5), SiC semiconductor device 200 shown in Fig. 7 is produced.

As described above, the fabrication method of a SiC semiconductor device according to the present embodiment includes the steps of preparing an epitaxial wafer 100 with a first surface 100a having impurities implanted at least partially (step S1), forming a second surface 100b by hydrogen-etching first surface 100a (step S2), and forming a gate oxide film 126 constituting SiC semiconductor device 200 on second surface 100b (step S3). At the step of forming gate oxide film 126 (step S3), semiconductor film 201 containing Si is formed on second surface 100b, and semiconductor film 201 is oxidized to form gate oxide film 126.

The inventors drew their attention to the fact that there is the case where gate oxide film 126 is not formed evenly in the step of forming gate oxide film 126 by oxidizing second surface 100b having impurities implanted at least partially. Specifically, second surface 100b having an ion implantation region includes a region where impurities are implanted and a region where impurities are not implanted. Furthermore, in the region where impurities are implanted, the implanted impurities differ, and concentration thereof is also different. Since the oxidation rate of the SiC semiconductor differs depending upon the concentration and type of the impurities, variation will occur in the oxidation rate in the depth direction at each spot in-plane when epitaxial wafer 100 having such a second surface 100b is oxidized.

As a result of diligent study to form an even gate oxide film 126, the inventors found that an even gate oxide film 126 can be produced by forming a film containing Si on second surface 100b, and then oxidizing the same to form gate oxide film 126.

Therefore, in the present embodiment, after forming second surface 100b by hydrogen-etching first surface 100a of epitaxial wafer 100 in step S2, a semiconductor film 201 containing Si is formed on second surface 100b. Then, semiconductor film 201 is oxidized to become gate oxide film 126. Accordingly, semiconductor film 201 can be formed on a cleaned second surface 100b, without depending on the concentration and type of the impurities at second surface 100b. Since impurities are not implanted into semiconductor film 201, the quality thereof is rendered uniform, allowing a uniform oxidization rate in the depth direction at each spot in-plane of semiconductor film 201. Therefore, a gate oxide film 126 of further uniform quality can be formed on a clean second surface 100b, allowing further improvement in the quality of SiC semiconductor device 200.

According to the present embodiment, the insulation property of gate oxide film 126 can be improved, and impurities, particles and the like present at the interface between epitaxial wafer 100 and gate oxide film 126 and in gate oxide film 126 can be reduced. Moreover, the uniformity in the quality of gate oxide film 126 can be improved. Thus, the quality of SiC semiconductor device 200 can be further improved.

In the case where fabrication apparatus 10 of Fig. 1 is to be used in the present embodiment, a device for forming semiconductor film 201 containing the Si element, preferably a CVD device, is included in any of removal unit 11 and formation unit 12. The site where the device for forming semiconductor film 201 is provided is not limited to removal unit 11 or formation unit 12, and may be provided additionally between removal unit 11 and connection unit 13, or between connection unit 13 and formation unit 12. In this case, epitaxial wafer 100 is preferably arranged in an atmosphere having the air cut off at the region between the interior of the device for forming semiconductor film 201 and another connecting section.

Thus, semiconductor film 201 can be formed without exposing second surface 100b to the air. Furthermore, semiconductor film 201 can be oxidized without exposure to the air. Thus, a SiC semiconductor device 200 of a further high quality can be produced.

### EXAMPLE

### (Example 1)

In Example 1, epitaxial wafer 130 shown in Fig. 9 was used as a SiC semiconductor. The effect of hydrogen-etching first surface 130a of epitaxial wafer 130 for cleaning was examined. Fig. 9 is a schematic sectional view of an epitaxial wafer employed in Example 1, and Comparative Examples 1 and 2.

Specifically, a 4H-SiC substrate having a surface 2a was prepared as a SiC substrate 2. As a layer constituting epitaxial layer 120, an n type SiC layer 131 having a thickness of 10 µm and an impurity concentration of 1 × 10¹⁶ cm⁻³ was grown by CVD.

Using SiCO₂ as a mask, a p body region 123 having the dopant concentration of 2 × 10¹⁶cm⁻³ with aluminum (Al) as the p type impurity was formed. In addition, an n⁺ source region 124 having the impurity concentration of 1 × 10¹⁹cm⁻³ with phosphorus (P) as the n type impurity was formed. Furthermore, a p⁺ region 125 having the impurity concentration of 1 × 10¹⁹cm⁻³ with aluminum (Al) as the p type impurity was formed.

Then, activation annealing was carried out. The activation annealing process was carried out under the conditions of 1700-1800 °C as the heating temperature and 30 minutes as the heating time, using Ar gas as the atmospheric gas. Thus, an epitaxial wafer 130 having first surface 130a was prepared (step S1).

Then, first surface 130a of the main surface of prepared epitaxial wafer 100 was removed by hydrogen-etching (step S2).

Specifically, epitaxial wafer 130 was placed in a reaction chamber. Epitaxial wafer 130 was heated at a base that was controlled at a temperature greater than or equal to 1300°C and less than or equal to 1650°C while first surface 130a was hydrogen-etched. For the hydrogen-etching conditions, the flow rate of hydrogen gas introduced into the reaction chamber was 50 to 200 slm, the pressure in the furnace was 20-150 hPa, and the reaction time was 1 hour.

### (Comparative Example 1)

Comparative Example 1 was basically similar to Example 1, provided that hydrogen-etching of step S2 was not carried out. In other words, epitaxial wafer 130 prepared at step S1 was not subjected to a cleaning process in Comparative Example 1.

### (Comparative Example 2)

Comparative Example 2 was basically similar to Example 1, provided that the surface of the SiC semiconductor was cleaned by chemical solution rinsing using the liquid phase, instead of hydrogen-etching. For the liquid phase, a mixture solution 1 having sulfuric acid (H₂SO₄): hydrogen peroxide solution (H₂O₂) mixed at the volume ratio of 5:1, a mixture solution 2 having aqueous ammonia: hydrogen peroxide solution: deionized water mixed at the volume ratio of 1:1:5, a mixture solution 3 having hydrogen chloride (HCl): hydrogen peroxide: deionized water mixed at the volume ratio of 1:1:6, and 10% hydrogen fluoride (HF) solution was used. Specifically, in Comparative Example 2, the prepared epitaxial wafer 130 was immersed in mixture solution 1 for 0.5 hours, then immersed in mixture solution 2 for ten minutes, immersed in HF solution for ten minutes, immersed in mixture solution 3 for ten minutes, immersed in mixture solution 2 for ten minutes, and immersed in HF solution for ten minutes, for cleaning by a chemical solution. Epitaxial wafer 130 subjected to cleaning through chemical solution was blown with argon gas or N₂ gas using an Ar gun or N₂ gun to be dried.

### (Measurement of Surface Impurity)

The surface of epitaxial wafer 130 of Example 1, Comparative Example 1 and Comparative Example 2 was subjected to TXRF (total reflection X-ray fluorescent analysis). In the TXRF, W (tungsten)-Lβ radiation was used as the excitation source.

The impurities at the surface of epitaxial wafer 130 of Example 1, Comparative Example 1, and Comparative Example 2 were measured by TXRF. The surface of epitaxial wafer 130 after hydrogen-etching in Example I had impurities reduced, as compared to the surface of Comparative Example I absent of hydrogen-etching. Therefore, it was appreciated that a SiC semiconductor device of high quality can be produced by fabricating a SiC semiconductor device by forming a gate oxide film and electrodes at epitaxial wafer 130 subjected to hydrogen-etching.

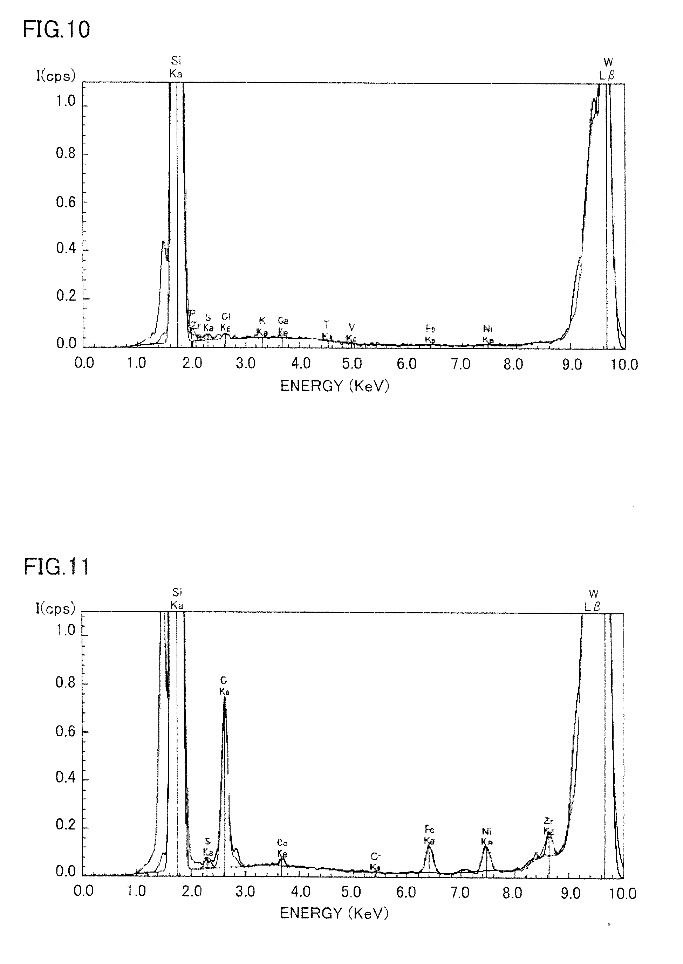

It was also appreciated that the surface of epitaxial wafer 130 after being cleaned using a liquid phase in Comparative Example 2 has more impurities than in Comparative Example 1. The results are shown in Figs. 10 and 11.

Fig. 10 represents a spectrum of the results of the surface of the SiC semiconductor of Comparative Example 1 measured by TXRF. Fig. 11 represents a spectrum of the results of the surface of the SiC semiconductor of Comparative Example 2 measured by TXRF. In each of these drawings, the energy intensity is plotted among the horizontal axis, and the spectral intensity is plotted along the vertical axis. A higher peak indicates that more of the relevant element has been detected. For example, "Cl, Ka" indicated vertically in Fig. 10 shows that a Cl-Kα radiation was detected. The same applies to other descriptions. The peak in the vicinity of 9.67 eV in energy intensity is the peak of the W-Lβ radiation that is the excitation radiation source.

Upon comparing Figs. 10 and 11, only chlorine (Cl) is detected in Comparative Example I, whereas chlorine (Cl), calcium (Ca), nickel (Ni) and iron (Fe) are detected in Comparative Example 2. It was therefore appreciated that, when the surface of epitaxial wafer 130 was subjected to a conventional cleaning process, the surface was only not cleaned, but had more adhering impurities.

Therefore, by fabricating a SiC semiconductor device based on forming an oxide film and electrodes, without subjecting epitaxial wafer 130 to cleaning through a liquid phase, after hydrogen-etching in Example 1, it was appreciated that a SiC semiconductor device of higher quality can be fabricated, as compared to the SiC semiconductor device of Comparative Example 2.

Although embodiments and examples of the present invention have been described in the foregoing, it is initially intended that the features of each embodiment and example are combined appropriately. It is to be understood that the embodiments and examples disclosed herein are only by way of example, and not to be taken by way of limitation. The scope of the present invention is not limited by the above-described embodiments and examples, but rather by the terms of the appended claims, and is intended to include any modifications within the scope and meaning equivalent to the terms of the claims.

### REFERENCE SIGNS LIST

2 SiC substrate; 2a surface; 10 fabrication apparatus; 11 removal unit; 12 formation unit; 13 connection unit; 100, 130 epitaxial wafer; 100a, 130a first surface; 100b second surface; 110 gate electrode; 111 source contact electrode; 112 drain electrode; 120 epitaxial layer; 121 buffer layer; 122 drift layer; 123 body region; 124 source region; 125 p⁺ region; 126 gate oxide film; 127 source electrode; 200 SiC semiconductor device; 201 semiconductor film.

## Claims

1. A method of fabricating a silicon carbide semiconductor device (200), comprising the steps of
preparing a silicon carbide semiconductor (100) including a first surface (100a) having impurities implanted at least partially,
forming a second surface (100b) by dry etching said first surface (100a) of said silicon carbide semiconductor (100) using gas including hydrogen gas, and
forming an oxide film (126) constituting said silicon carbide semiconductor device (200) on said second surface (100b).

2. The method of fabricating a silicon carbide semiconductor device (200) according to claim 1, wherein said step of forming an oxide film (126) is carried out after said step of forming a second surface (100b), without cleaning using a liquid phase.

3. The method of fabricating a silicon carbide semiconductor device (200) according to claim 1, wherein said dry etching is carried out in a temperature range greater than or equal to 1300°C and less than or equal to 1650°C in said step of forming a second surface (100b).

4. The method of fabricating a silicon carbide semiconductor device (200) according to claim 1, wherein, in said step of forming an oxide film (126), said oxide film (126) is formed by forming a film (201) containing silicon on said second surface (100b), and oxidizing said film (201) containing silicon.

5. The method of fabricating a silicon carbide semiconductor device (200) according to claim 1, wherein said gas further includes hydrogen chloride gas in said step of forming a second surface (100b).

6. The method of fabricating a silicon carbide semiconductor device (200) according to claim 1, wherein said gas further includes hydrocarbon gas in said step of forming a second surface (100b).

7. The method of fabricating a silicon carbide semiconductor device (200) according to claim 1, wherein said silicon carbide semiconductor (100) is arranged in an atmosphere having air cut off between said step of forming a second surface (100b) and said step of forming an oxide film (126).

8. A fabrication apparatus (10) of a silicon carbide semiconductor device (200), comprising:
a removal unit (11) for removing a first surface (100a) having impurities implanted at least partially of a silicon carbide semiconductor (100) by dry etching using gas including hydrogen gas,
a formation unit (12) for forming an oxide film (126) constituting said silicon carbide semiconductor device (200) at a second surface (100b) formed by having said first surface (100a) removed at said silicon carbide semiconductor (100), and
a connection unit (13) connecting said removal unit (11) and said formation unit (12) in a manner allowing said silicon carbide semiconductor (100) to be transferred,
wherein a region of said connection unit (13) where said silicon carbide semiconductor (100) is transferred can have air cut off.
